# EUROPEAN PATENT APPLICATION

(11) **EP 4 506 989 A2**
(43) Date of publication of application: **12.02.2025**
(21) Application number: 24187776.0
(22) Date of filing: 10.07.2024
(51) Int. Cl.: H01L 21/768, H01L 23/528

(54) **INTERCONNECT STRUCTURE INCLUDING METAL LINE AND TOP VIA FORMED THROUGH DIFFERENT PROCESSES**

(30) Priority: 11.07.2023 US 202363526091 P; 11.10.2023 US 202318378789
(71) Applicant: Samsung Electronics Co., Ltd, Suwon-si, Gyeonggi-do 16677 (KR)
(72) Inventor: CHOI, Jaemyung, Suwon-si, Gyeonggi-do 16677 (KR); LEE, Janggeun, Suwon-si, Gyeonggi-do 16677 (KR); HONG, Wonhyuk, Suwon-si, Gyeonggi-do 16677 (KR); SEO, Kang-ill, San Jose, CA, 95134 (US)
(74) Representative: Kuhnen & Wacker Patent- und Rechtsanwaltsbüro PartG mbB

(57) **Abstract**

A semiconductor device (20) includes: a frontside structure (200) including at least one of a front-end-of-line, FEOL, structure, a middle-of-line, MOL, structure, and a back-end-of-line, BEOL, structure; a 1^{st} metal line (210) on the frontside structure (200); and a 2^{nd} metal line (240) on the frontside structure (200), wherein the 1^{st} metal line (210) has a greater width than the 2^{nd} metal line (240) in a same direction (D1), and the 1^{st} metal line (210) and the 2^{nd} metal line (240) have an equal height.

## Description

### BACKGROUND

### 1. Field

Apparatuses and methods consistent with example embodiments of the disclosure relate to an interconnect structure including a metal line and a top via formed thereon, and more particularly to, a semiconductor device including a metal line and a top via which are formed through different processes.

### 2. Description of the Related Art

Performance of a semiconductor device may be affected by how an interconnect structure is formed in the semiconductor device. The interconnect structure may include back-end-of-line (BEOL) structures such as metal lines and vias which connect front-end-of-line (FEOL) structures to a voltage source or other circuit elements through middle-of-line (MOL) structures. The FEOL structures may include source/drain regions and gate structures of a transistor, and the MOL structures may include contact plugs or vias formed on the source/drain regions or the gate structures.

As semiconductor devices are developed to have a high device density and performance, design and formation of an interconnect structure becomes more difficult and complicated while improved resistance and capacitance (RC) characteristics are required for the semiconductor device.

Information disclosed in this background section has already been known to the inventors before achieving the embodiments of the present application or is technical information acquired in the process of achieving the embodiments described herein. Therefore, it may contain information that does not form prior art that is already known to the public.

### SUMMARY

The disclosure provides example embodiments of an interconnect structure for a semiconductor device or an integrated circuit and a method of manufacturing the same.

According to embodiments, there is provided a semiconductor device which may include: a frontside structure including at least one of a front-end-of-line (FEOL) structure, a middle-of-line (MOL) structure, and a back-end-of-line (BEOL) structure; a 1^{st} metal line on the frontside structure; and a 2^{nd} metal line on the frontside structure, wherein the 1^{st} metal line has a greater width than the 2^{nd} metal line in a same direction, and the 1^{st} metal line and the 2^{nd} metal line have an equal height.

The 1^{st} metal line may have a 1^{st} top via formed thereon without an intervening layer such as a barrier metal line therebetween. The 1^{st} top via and the 1^{st} metal line may be a single continuum structure formed of a same material such as ruthenium (Ru).

According to embodiments, there is provided a semiconductor device which may include: a frontside structure including at least one of a front-end-of-line (FEOL) structure, a middle-of-line (MOL) structure, and a back-end-of-line (BEOL) structure; a 1^{st} metal line; and a 1^{st} top via on the 1^{st} metal line without an intervening layer therebetween, wherein the 1^{st} metal line and the 1^{st} top via have a same material composition, and the 1^{st} metal line and the 1^{st} top via have different material structures.

The 1^{st} metal line may have a columnar material structure, and the 1^{st} top via may have an amorphous or polycrystalline structure.

According to embodiments, there is provide a method of forming an interconnect structure for a semiconductor device. The method may include: (a) forming a 1^{st} initial metal structure by a 1^{st} deposition process; (b) forming a 2^{nd} initial metal structure on the 1^{st} initial metal structure by a 2^{nd} deposition process; (c) forming a plurality of hard mask patterns on the 2^{nd} initial metal structure at selected positions; (d) patterning the 2^{nd} initial metal structure and the 1^{st} initial metal structure thereunder based on the hard mask patterns to form at least one narrow structure and at least one wide structure each of which includes a metal structure and a via structure thereon; (e) patterning the hard mask patterns to form reduced hard mask patterns; and (f) patterning the via structure in each of the narrow structure and the wide structure at the same time based on the reduced hard mask patterns until portions of the via structures not covered by the reduced hard mask patterns are entirely removed, whereby a wide metal line and a narrow metal line having respective top vias thereon may be formed.

The 1^{st} deposition process may be one of physical vapor deposition (PVD) and chemical vapor deposition (CVD), and the 2^{nd} deposition process may be the other of the PVD and the CVD.

### BRIEF DESCRIPTION OF DRAWINGS

Example embodiments of the disclosure will be more clearly understood from the following detailed description taken in conjunction with the accompanying drawings in which:
FIGS. 1A-1E illustrate a semiconductor device including an interconnect structure formed of a plurality of metal lines and top vias, according to comparative examples;
FIGS. 2-11 illustrate intermediate semiconductor devices including intermediate interconnect structures obtained from respective steps of forming an interconnect structure including a wide metal line and a narrow metal line with respective top vias thereon and having different heights, according to comparative examples;
FIGS. 12A-12D illustrate a semiconductor device including an interconnect structure formed of a plurality of metal lines and top vias, according to embodiments;
FIGS. 13-23 illustrate intermediate semiconductor devices including intermediate interconnect structures obtained from respective steps of forming an interconnect structure including a wide metal line and a narrow metal line with respective top vias thereon and having a same height, according to embodiments;
FIG. 24 illustrates a flowchart for a method of forming an interconnect structure in which a wide metal line and a narrow metal line have respective top vias thereon and have a same height, according to embodiments; and
FIG. 25 is a schematic block diagram illustrating an electronic device including an interconnect structure 200A as shown in FIGS. 12A-12D, according to an example embodiment.

### DETAILED DESCRIPTION OF EMBODIMENTS

The embodiments of the disclosure described herein are example embodiments, and thus, the disclosure is not limited thereto, and may be realized in various other forms. Each of the embodiments provided in the following description is not excluded from being associated with one or more features of another example or another embodiment also provided herein or not provided herein but consistent with the disclosure. For example, even if matters described in a specific example or embodiment are not described in a different example or embodiment thereto, the matters may be understood as being related to or combined with the different example or embodiment, unless otherwise mentioned in descriptions thereof. In addition, it should be understood that all descriptions of principles, aspects, examples, and embodiments of the disclosure are intended to encompass structural and functional equivalents thereof. In addition, these equivalents should be understood as including not only currently well-known equivalents but also equivalents to be developed in the future, that is, all devices invented to perform the same functions regardless of the structures thereof. For example, channel layers, sacrificial layers, and isolation layers described herein may take a different type or form as long as the disclosure can be applied thereto.

It will be understood that when an element, component, layer, pattern, structure, region, or so on (hereinafter collectively "element") of a semiconductor device is referred to as being "over," "above," "on," "below," "under," "beneath," "connected to" or "coupled to" another element the semiconductor device, it can be directly over, above, on, below, under, beneath, connected or coupled to the other element or an intervening element(s) may be present. In contrast, when an element of a semiconductor device is referred to as being "directly over," "directly above," "directly on," "directly below," "directly under," "directly beneath," "directly connected to" or "directly coupled to" another element of the semiconductor device, there are no intervening elements present. Like numerals refer to like elements throughout this disclosure.

Spatially relative terms, such as "over," "above," "on," "upper," "below," "under," "beneath," "lower," "left," "right," "lower-left," "lower-right," "upper-left," "upper-right," "central," "middle," and the like, may be used herein for ease of description to describe one element's relationship to another element(s) as illustrated in the figures. It will be understood that the spatially relative terms are intended to encompass different orientations of a semiconductor device in use or operation in addition to the orientation depicted in the figures. For example, if the semiconductor device in the figures is turned over, an element described as "below" or "beneath" another element would then be oriented "above" the other element. Thus, the term "below" can encompass both an orientation of above and below. The semiconductor device may be otherwise oriented (rotated 90 degrees or at other orientations) and the spatially relative descriptors used herein interpreted accordingly. As another example, when elements referred to as a "left" element and a "right" element" may be a "right" element and a "left" element when a device or structure including these elements are differently oriented. Thus, in the descriptions herebelow, the "left" element and the "right" element may also be referred to as a "1^{st}" element or a "2^{nd}" element, respectively, as long as their structural relationship is clearly understood in the context of the descriptions. Similarly, the terms a "lower" element and an "upper" element may be respectively referred to as a "1^{st}" element and a "2^{nd}" element with necessary descriptions to distinguish the two elements.

It will be understood that, although the terms "1^{st}," "2^{nd}," "3^{rd}," "4^{th}," "5^{th}," "6^{th}," etc. may be used herein to describe various elements, these elements should not be limited by these terms. These terms are only used to distinguish one element from another element. Thus, a 1^{st} element discussed below could be termed a 2^{nd} element without departing from the teachings of the disclosure.

As used herein, expressions such as "at least one of," when preceding a list of elements, modify the entire list of elements and do not modify the individual elements of the list. For example, the expression, "at least one of a, b and c," should be understood as including only a, only b, only c, both a and b, both a and c, both b and c, or all of a, b and c. Herein, when a term "same" or "equal" is used to compare a dimension of two or more elements, the term may cover a "substantially same" or "substantially equal" dimension.

It will be also understood that, even if a certain step or operation of manufacturing an apparatus or structure is described later than another step or operation, the step or operation may be performed later than the other step or operation unless the other step or operation is described as being performed after the step or operation.

Many embodiments are described herein with reference to cross-sectional views that are schematic illustrations of the embodiments (and intermediate structures). As such, variations from the shapes of the illustrations as a result, for example, of manufacturing techniques and/or tolerances, are to be expected. Thus, the embodiments should not be construed as limited to the particular shapes of regions illustrated herein but are to include deviations in shapes that result, for example, from manufacturing. Various regions illustrated in the figures are schematic in nature and their shapes are not intended to illustrate the actual shape of a region of a device and are not intended to limit the scope of the disclosure. Further, in the drawings, the sizes and relative sizes of layers and regions may be exaggerated for clarity.

For the sake of brevity, conventional elements of a semiconductor device may or may not be described in detail herein or shown in the drawings. For example, an MOL or FEOL structure may not be shown or described in detail when the structure is not relevant to the concept of the disclosure.

Herebelow, various embodiments of the disclosure are described with reference to the accompanying drawings.

A top via has been introduced to reduce contact resistance and capacitance that may occur between a metal line and a via formed thereon to adversely affect at least connection performance of a semiconductor device including the metal line and the via.

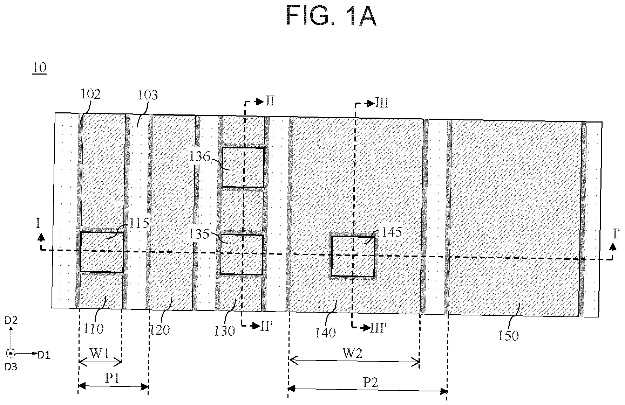

FIGS. 1A-1E illustrate a semiconductor device including an interconnect structure formed of a plurality of metal lines and top vias, according to comparative examples.

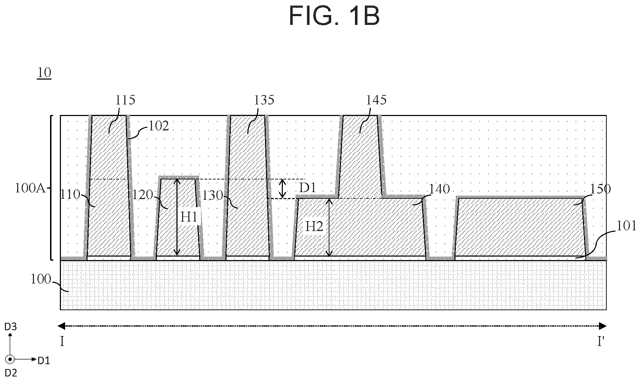

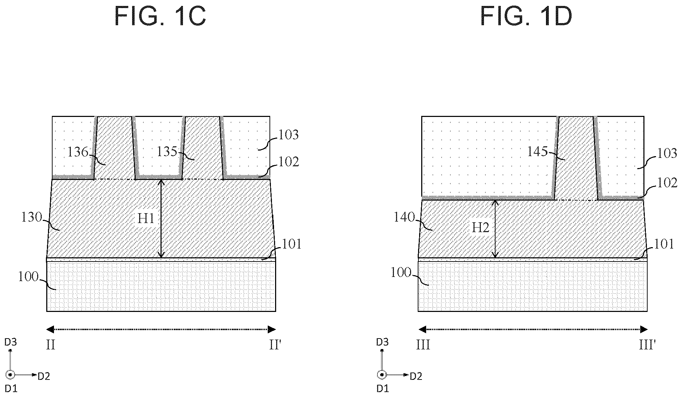

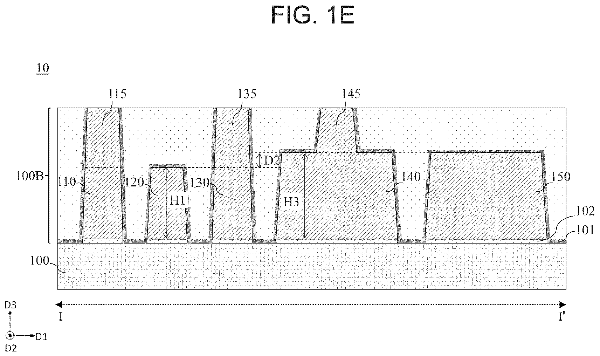

FIG. 1A is a plan view of a semiconductor device including an interconnect structure, and FIG. 1B is a side cross-sectional view taken along a line I-I' shown in FIG. 1A. FIGS. 1C and 1D are side cross-sectionals view taken along a line II-II' and a line III-III' shown in FIG. 1A, respectively. FIG. 1E is an alternative side cross-sectional view taken along the line I-I' shown in FIG. 1A.

Referring to FIGS. 1A-1D, a semiconductor device 10 may include an interconnect structure 100A formed on a frontside structure 100 with a 1^{st} adhesive layer 101 therebetween. The interconnect structure 100A may include 1^{st} to 5^{th} metal lines 110-150 arranged in a D1 direction and extended in a D2 direction intersecting the D1 direction. Here, the frontside structure 100 may be at least one of an FEOL structure, an MOL structure and a BEOL structure. Thus, the semiconductor device 10 may be a single integrated circuit (IC) device or IC chip such as a memory chip or system-on-chip (SoC).

The metal lines 110-150 may each be formed of a metal such as ruthenium (Ru), molybdenum (Mo), tungsten (W), cobalt (Co), or their compound, not being limited thereto. The 1^{st} adhesive layer 101 between the frontside structure 100 and each of the 1^{st} to 5^{th} metal lines 110-150 may be formed of a material such as titanium nitride (TiN), tantalum nitride (TaN), or an equivalent material, which may conductively connect the metal lines 110-150 to the frontside structure 100.

On the 1^{st} metal line 110 and the 3^{rd} metal line may be formed a 1^{st} top via 115, a 2^{nd} top via 135 and a 3^{rd} top via 136 in a form of protrusion in a D3 direction from top surfaces of the 1^{st} metal line 110 and the 3^{rd} metal line 130, respectively. In addition, a 4^{th} top via 145 may be formed on a 4^{th} metal line 140 in the form of protrusion in the D3 direction from a top surface of the 4^{th} metal line 140. The D3 direction intersects the D1 direction and the D2 direction. The top vias 115, 135, 136 and 145 may be formed of the same material forming the metal lines 110-150 as each of the top vias and a corresponding metal line form a single continuum structure as described below.

The metal lines 110-150 and the top vias 115, 135, 136 and 145 may be surrounded by an isolation structure 103 with a 2^{nd} adhesive layer 102 therebetween. The isolation structure 103 may isolate or insulate these metal lines and top vias from each other or from other circuit elements, and the 2^{nd} adhesive layer 102 may facilitate adhesion of the metal lines and top vias to the isolation structure 103 and protect the metal lines and top vias from other processes including an annealing process performed when the isolation structure 103 is formed thereon. One or more materials forming the isolation structure 103 may include a low-k dielectric material such as silicon oxide (e.g., SiO₂, SiCOH, etc.) not being limited thereto. One or more materials forming the 2^{nd} adhesive layer may also include a low-k material such as silicon nitride (e.g., SiN, Si₃N₄, etc.)

It is understood here that FIG. 1A does not show portions of the isolation structure 103 which are formed on top surfaces of the metal lines and side surfaces of the top vias as shown in FIGS. 1B-1D, because they may obscure the metal lines thereunder in FIG. 1A.

Here, the top via refers to a via connection structure formed on a metal line without an intervening layer such as a barrier metal line which may include a titanium (Ti), tantalum (Ta), titanium nitride (TiN), tantalum nitride (TaN), etc. Further, there may be no boundary, interface, seam or connection surface (collectively, "connection surface") between the metal line and the top via. Conventionally, a metal line and a via of a semiconductor device are formed though a damascene process, in which an isolation structure formed on an MOL or FEOL structure or another BEOL structure is patterned and the metal and the via are respectively formed in the patterned isolation layer at vertically adjacent layers of the isolation structure. In contrast, the top via may be formed by patterning a metal structure itself, and thus, no intervening layer or connection surface may be formed between the top via and the patterned underlying metal structure which forms a metal line of a semiconductor device. Accordingly, the 1^{st} metal line 110 and the 1^{st} top via 115 thereon may form a single continuum metal structure without a connection surface or an intervening layer therebetween. Likewise, the 3^{rd} metal line 130 and each of the 2^{nd} top via 135 and the 3^{rd} top via 136 thereon may form another single continuum metal structure without a connection surface or intervening layer therebetween. Thus, the material forming the top vias 115, 135, 136 and 145 may also be formed of the same metal forming the corresponding metal lines 110, 130 and 140. It is understood here that a dashed line between each of the top vias 115, 135, 136 and 145 and each of the corresponding metal lines 110, 130 and 140 as shown in FIGS. 1B-1D does not indicate existence of a connection surface or intervening layer described above because there is no such connection surface therebetween. These dashed lines are shown in the drawings only to indicate a top via and a corresponding metal line distinctly.

Referring to FIGS. 1A and 1B, each of the 1^{st} to 3^{rd} metal lines 110-130 may be a narrow metal line having a 1^{st} width W1, and arranged at a 1^{st} pitch P1 in the D1 direction. Each of the 4^{th} and 5^{th} metal lines 140 and 150 may be a wide metal line having a 2^{nd} width W2, and arranged at a 2^{nd} pitch P2 in the same D1 direction. The 1^{st} width W1 may be smaller than the 2^{nd} width W2, and the 1^{st} pitch P1 may be smaller than the 2^{nd} pitch P2. In the semiconductor device 10, the 4^{th} metal line 140 and the 5^{th} metal line 150 may each be used as a power rail connecting the frontside structure 100 to a voltage source as they have a relatively greater width, and the 1^{st} to 3^{rd} metal lines 110-130 may each be used as a signal line for internal routing.

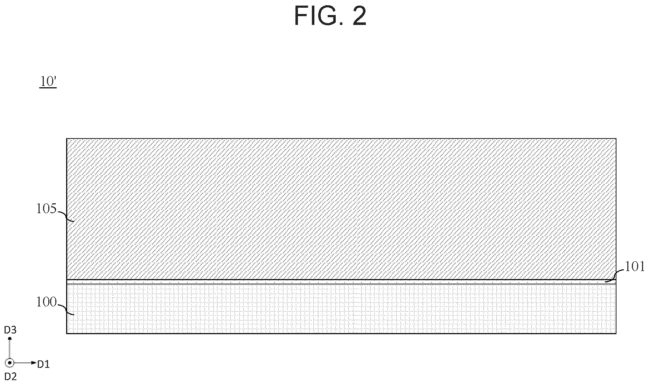

In the meantime, FIGS. 1B-1D show that a height H2 of each of the 4^{th} metal line 140 and the 5^{th} metal line 150 is smaller than a height H1 of each of the 1^{st} to 3^{rd} metal lines 110-130 by a depth D1. Accordingly, a height of the 4^{th} top via 145 is greater than each of the 1^{st} to 3^{rd} top vias 115, 135 and 136 by the depth D1. This is because the 4^{th} metal line 140 and the 5^{th} metal line 150 are wide metal lines while the 1^{st} to 3^{rd} metal lines 110-130 are narrow metal lines. As will be described later with reference to FIGS. 2-11, the 1^{st} to 4^{th} top vias 115, 135, 136 and 145 may be formed by patterning respective metal structures based on a same initial metal structure through a same patterning process (e.g., dry etching), and thus, wide metal structures may be patterned faster than narrow metal structures. Therefore, the 4^{th} metal line 140 and the 5^{th} metal line 150 patterned from the wide metal structures may have a smaller height than the 1^{st} to 3^{rd} metal lines 110-130 patterned from the narrow metal structures.

However, the present disclosure is not limited to the interconnect structure 100A shown in FIG. 1B. According to comparative examples, the semiconductor device 10 may have an interconnect structure 100B which is different from the interconnect structure 100A shown in FIG. 1B. For example, as shown in FIG. 1E, the interconnect structure 100B may include the 4^{th} metal line 140 and the 5^{th} metal line 150 which may be formed to have a height H3 which is greater than the height H1 of the 1^{st} to 3^{rd} metal lines 110-130 by a depth D2, subject to a patterning process variation. Still, however, because of the different widths between the wide metal structure and the narrow metal structure, the wide metal lines and the narrow metal lines respectively patterned therefrom through a same patterning process may have different heights.

FIGS. 2-11 illustrate intermediate semiconductor devices including intermediate interconnect structures obtained from respective steps of forming an interconnect structure including a wide metal line and a narrow metal line having different heights, according to comparative examples. Here, the interconnect structure completed from the intermediate interconnect structures through the respective steps described herebelow may be the same as or corresponding to the interconnect structure 100A of the semiconductor device 10 shown in FIGS. 1A-1D. Thus, duplicate descriptions may be omitted, and the same reference numbers and characters used in the descriptions of the interconnect structure 100A of the semiconductor device 10 may be used herebelow.

Referring to FIG. 2, an initial metal structure 105 may be formed on the frontside structure 100 of an intermediate semiconductor device 10'. The initial metal structures 105 may extend in the D1 direction and the D2 direction on the frontside structure 100 which may be at least one of an FEOL structure, an MOL structure and a BEOL structure.

Prior to formation of the initial metal structure 105 on the frontside structure 100, the 1^{st} adhesive layer 101 may be layered on a top surface of the frontside structure 100 through, for example, atomic layer deposition (ALD), not being limited thereto. Then, the initial metal structure 105 may be formed on the 1^{st} adhesive layer 101 through, for example, physical vapor deposition (PVD), chemical vapor deposition (CVD), plasma-enhanced chemical vapor deposition, or any other deposition process, and planarized through, for example, chemical-mechanical polishing (CMP).

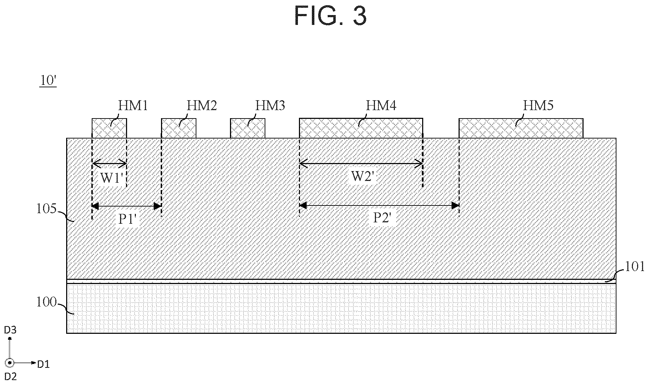

Referring to FIG. 3, 1^{st} to 5^{th} hard mask patterns HM1-HM5 may be formed on a top surface of the initial metal structure 105 at positions where the 1^{st} to 5^{th} metal lines 110-150 shown in FIGS. 1A-1D are to be respectively formed thereunder through, for example, a photolithography and masking operation.

As the 1^{st} to 5^{th} metal lines 110-150 are to be formed based on the 1^{st} to 5^{th} hard mask patterns HM1-HM5, respectively, the 1^{st} to 5^{th} hard mask patterns HM1-HM5 may be arranged in the D1 direction at respective pitches P1' and P2' corresponding to the pitches P1 and P2 at which the 1^{st} to 5^{th} metal lines 110-150 are arranged in the D1 direction, as shown in FIG. 1A. The pitch P1' may be smaller than the pitch P2' as the pitch P1 is smaller than the pitch P2. Further, the 1^{st} to 5^{th} hard mask patterns HM1-HM5 may have widths corresponding to those of the 1^{st} to 5^{th} metal lines 110-150, respectively. For example, a width W1' of each of the 1^{st} to 3^{rd} hard mask patterns HM1-HM3 may be smaller than a width W2' of each of the 4^{th} and 5^{th} hard mask pattern HM4-HM5. This is because the 1^{st} to 3^{rd} hard mask patterns HM1-HM3 each will be used to pattern narrow metal lines, and the 4^{th} and 5^{th} hard mask pattern HM4-HM5 each will be used to pattern wide metal lines in a later step.

A material or material composition forming the 1^{st} to 5^{th} hard mask patterns HM1-HM5 may be silicon nitride (e.g., Si₃N₄) or silicon dioxide (e.g., SiO₂), not being limited thereto.

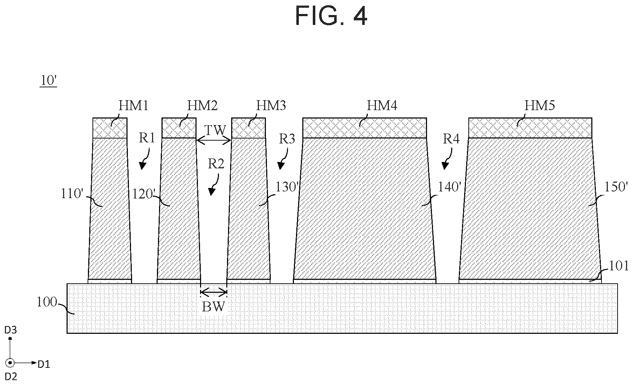

Referring to FIG. 4, the initial metal structure 105 and the 1^{st} adhesive layer 101 thereunder may be patterned based on the 1^{st} to 5^{th} hard mask patterns HM1-HM5 to form 1^{st} to 5^{th} metal structures 110'-150'.

The formation of the 1^{st} to 5^{th} metal structures 110'-150' may be performed through, for example, dry etching (e.g., reactive ion etching, plasma etching, ion beam etching, or laser ablation), not being limited thereto. Corresponding to the widths W1' and W2' shown in FIG. 3, the 1^{st} to 3^{rd} metal structures 110'-130' may each be formed as a narrow metal structure, while the 4^{th} and 5^{th} metal structures 140'-150' may each be formed as a wide metal structure.

It is understood here that, due to an etching aspect ratio, a width of each of recesses R1-R4 formed between the 1^{st} to 5^{th} metal structures 110'-150' by the etching operation may decreasingly vary along a depth direction of each recess. For example, the recess R2 between the 2^{nd} metal structure 120' and the 3^{rd} metal structure 130' may have a top width TW which is greater than a bottom width BW. Thus, each of the 1^{st} to 5^{th} metal structures 110'-150' may have a top width which is smaller than a bottom width thereof. Still, however, subject to accuracy of the etching operation, the top width and the bottom width of each of the recesses R1-R4 may be substantially equal to each other, and thus, the top width and the bottom width of each of the 1^{st} to 5^{th} metal structures 110'-150' may be substantially equal to each other.

The recesses R1-R4 formed between the 1^{st} to 5^{th} metal structures 110'-150' may expose a top surface of the frontside structure 100.

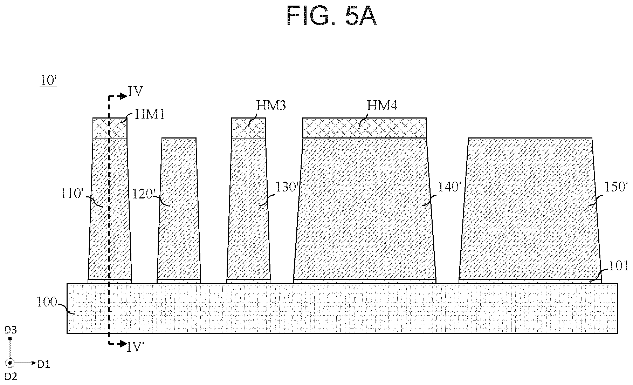

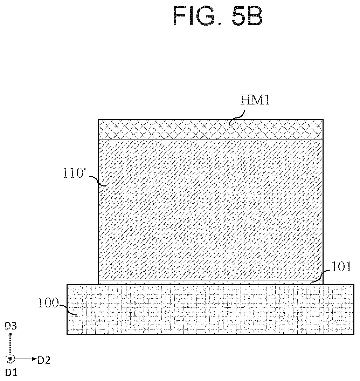

Referring to FIGS. 5A and 5B, the 2^{nd} hard mask pattern HM2 and the 5^{th} hard mask pattern HM5 among the 1^{st} to 5^{th} hard mask patterns HM1-HMS may be removed from the 2^{nd} metal structure 120' and the 5^{th} metal structure 150', respectively, while the 1^{st} hard mask pattern HM1, the 3^{rd} hard mask pattern HM3 and the 4^{th} hard mask pattern HM 4 remain on the 1^{st} metal structure 110', the 3^{rd} metal structure 130' and the 4^{th} metal structure 140', respectively.

The 2^{nd} hard mask pattern HM2 and the 5^{th} hard mask pattern HM5 may be selectively removed in this step to expose top surfaces of the 2^{nd} metal structure 120' and the 5^{th} metal structure 150' so that these metal structures can be recessed from the top surfaces thereof in a later step. The selective removal operation of the hard mask patterns HM2 and HM5 may be performed through, for example, ashing or stripping, not being limited thereto.

After the selective removal of the hard mask patterns HM2 and HM5, a side cross-sectional view in the D1 direction of the 1^{st} metal structure 110' with the 1^{st} hard mask pattern HM1 thereon may take a shape as shown in FIG. 5B which is a cross-sectional view of the intermediate semiconductor device 10' along a line IV-IV' of FIG. 5A. The 3^{rd} metal structure 130' with the 3^{rd} hard mask pattern HM3 thereon, and the 4^{th} metal structure 140' with the 4^{th} hard mask pattern HM4 thereon may have the same side cross-sectional view in the D1 direction as that of the 1^{st} metal structure 110' with the 1^{st} hard mask pattern HM1 thereon.

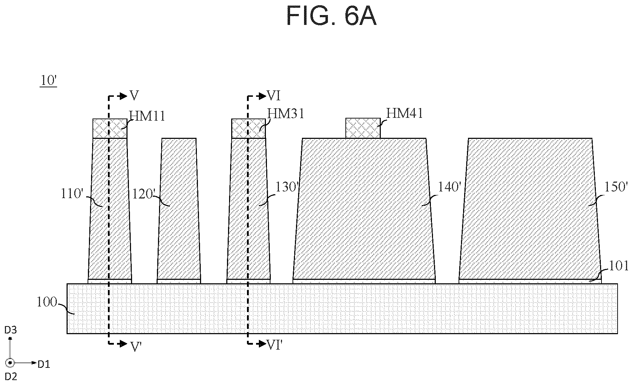

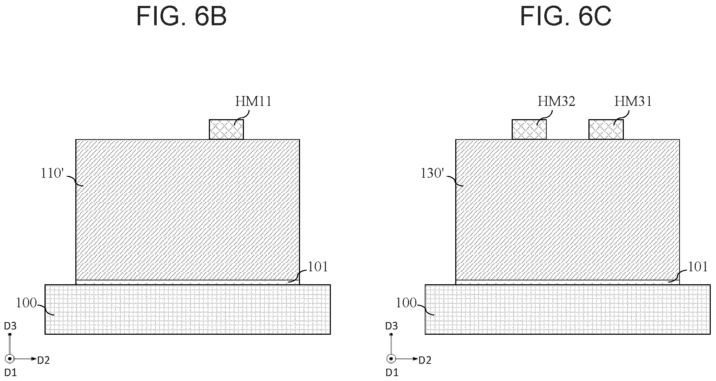

Referring to FIGS. 6A-6C, the 1^{st} hard mask pattern HM1, the 3^{rd} hard mask pattern HM3, and the 4^{th} hard mask pattern HM4 may be patterned to correspond to positions where the 1^{st} top via 115, the 2^{nd} and 3^{rd} top vias 135-136, and the 4^{th} top via 145 are to be formed thereunder in a later step. FIGS. 6B and 6C are cross-sectional views of the intermediate semiconductor device 10' along lines V-V' and VI-VI' of FIG. 6A, respectively.

The patterning of the 1^{st} hard mask pattern HM1, the 3^{rd} hard mask pattern HM3, and the 4^{th} hard mask pattern HM4 may be performed through, for example, another photolithography and masking operation.

After the patterning operation in this step, a reduced 1^{st} hard mask pattern HM11 may be formed on the 1^{st} metal structure 110', and reduced 3^{rd} hard mask patterns HM31 and HM32 may be formed on the 3^{rd} metal structure 130'. Further, a reduced 4^{th} hard mask pattern HM41 may be formed on the 4^{th} metal structure 140'.

FIG. 6B shows a side cross-sectional view in the D1 direction of the 1^{st} metal structure 110' with the reduced 1^{st} hard mask pattern HM11 thereon, which may be the same as that of the 4^{th} metal structure 140' with the reduced 4^{th} hard mask pattern HM41 thereon. FIG. 6C shows a side cross-sectional view in the D1 direction of the 3^{rd} metal structure 130' with the reduced 3^{rd} hard mask patterns HM31 and HM32 thereon.

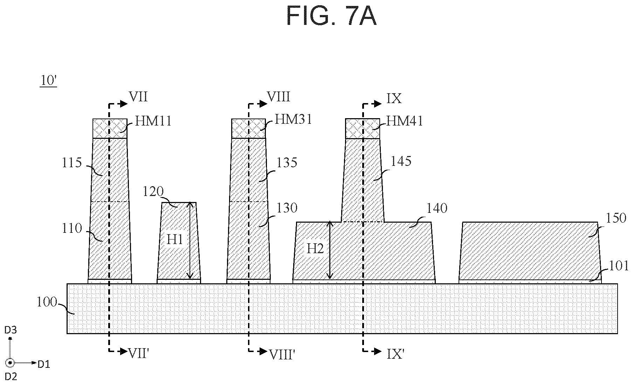

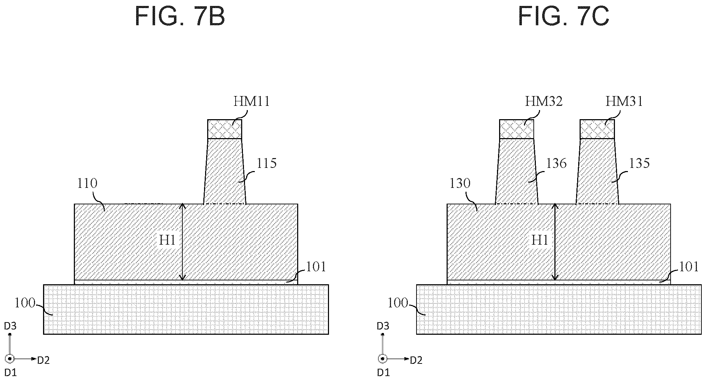

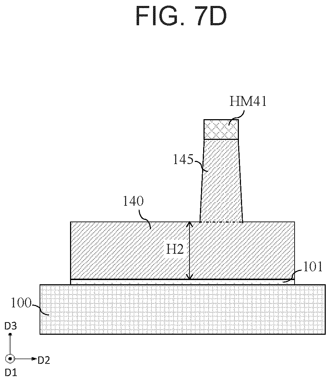

Referring to FIGS. 7A-7D, the 1^{st} to 5^{th} metal structures 110'-150' may be patterned based on the reduced hard mask patterns HM11, HM31-HM32 and HM41 obtained in the previous step. FIGS. 7B-7D are cross-sectional views of the intermediate semiconductor device 10' along lines VII-VII', VIII-VIII' and IX-IX' of FIG. 7A, respectively.

By this patterning operation, the 1^{st} metal line 110 with the 1^{st} top via 115 thereon, the 2^{nd} metal line 120, the 3^{rd} metal line 130 with the 2^{nd} and 3^{rd} top vias 135-136 thereon, the 4^{th} metal line 140 with the 4^{th} top via 145 thereon, and the 5^{th} metal line 150 may be formed on the frontside structure 100.

The patterning of the metal structures 110'-150' may be performed through, for example, dry etching (e.g., reactive ion etching, ion beam etching, or laser ablation). When dry etching is performed, the 1^{st} to 5^{th} metal structures 110'-150' with the reduced hard mask pattern HM11, HM31, HM32 and HM41 thereon may be exposed to a reactive gas in a vacuum chamber at the same time. At this time, the 4^{th} and 5^{th} metal structures 140'-150' (wide metal structures) may be etched more or less than the 1^{st} to 3^{rd} metal structures 110'-130' (narrow metal structures) because of the width difference thereof. Thus, the 1^{st} to 5^{th} metal lines 110-150 obtained by the patterning operation in this step may have different heights. For example, an etch rate may be higher on the 4^{th} and 5^{th} metal structures 140'-150' which provide a greater gas reaction surface than on the 1^{st} to 3^{rd} metal structures 110'-130' which provide a smaller gas reaction surface. Thus, each of the 4^{th} and 5^{th} metal lines 140-150 may be etched faster or more than each of the 1^{st} to 3^{rd} metal structures 110'-130' in a unit time. Accordingly, the 4^{th} and 5^{th} metal lines 140-150 may have the height H2 which is smaller than the height H1 of the 1^{st} to 3^{rd} metal lines 110-130 of by the depth D1 as shown in FIGS. 7A-7C.

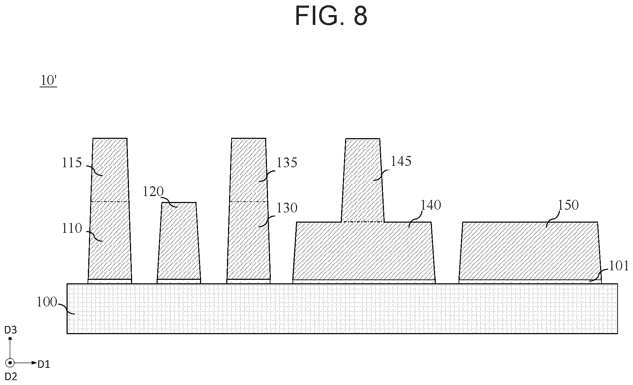

Referring to FIG. 8, the reduced 1^{st} hard mask pattern HM11, 3^{rd} hard mask patterns HM31-HM32 and 4^{th} hard mask pattern HM41 may be removed from the intermediate semiconductor device 10'.

The removal of the reduced hard mask patterns HM11, HM31, HM32 and HM41 in this step may be performed through, for example, ashing or stripping, not being limited thereto.

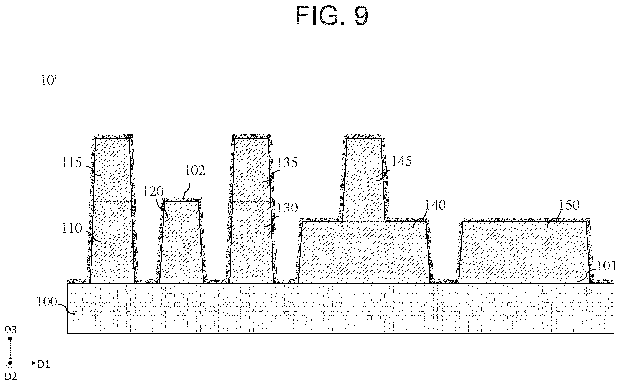

Referring to FIG. 9, the 2^{nd} adhesive layer 102 may be formed on the metal lines 110-150 and the top vias 115, 135, 136 and 145 to facilitate bonding of this intermediate interconnect structure to an isolation structure to be formed in a next step. The 2^{nd} adhesive layer 102 may also protect the intermediate interconnect structure from at least an annealing process that may be performed to form the isolation structure.

The formation of the 2^{nd} adhesive layer may be performed through, for example, at least one of atomic layer deposition (ALD), chemical vapor deposition (CVD), physical vapor deposition (PVD), and plasma-enhanced chemical vapor deposition (PECVD), not being limited thereto.

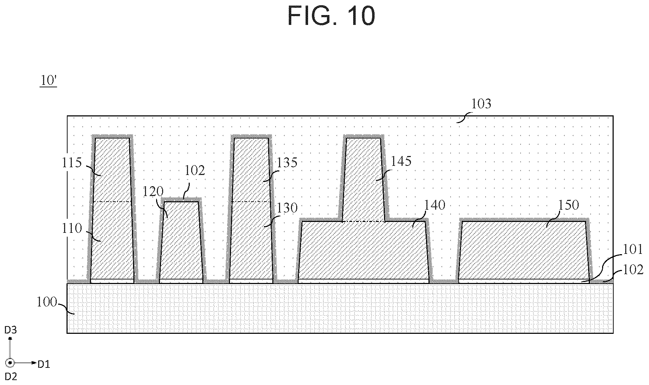

Referring to FIG. 10, the isolation structure 103 may be formed on the metal lines 110-150 and the top vias 115, 135, 136 and 145 to isolate these metal lines and top vias from each other or from other circuit elements.

The formation of the isolation structure 103 may be performed through, for example, at least one of chemical vapor deposition (CVD), physical vapor deposition (PVD), plasma-enhanced chemical vapor deposition (PECVD), and atomic layer deposition (ALD), not being limited thereto.

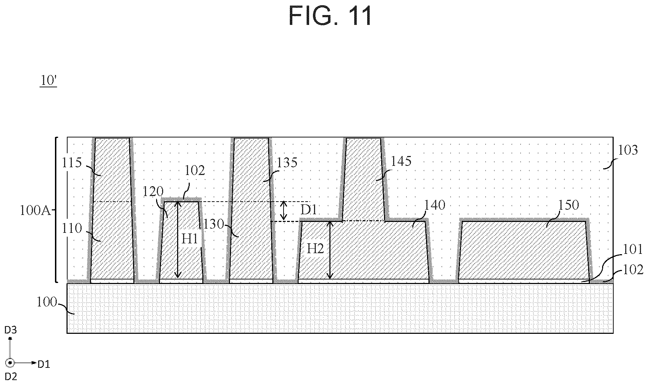

Referring to FIG. 11, the isolation structure 103 surrounding the metal lines 110-150 and the top vias 115, 135, 136 and 145 may be planarized to expose top surfaces of the top vias 115, 135, 136 and 145 for external connection of the intermediate semiconductor device 10'

The planarization in this step may be performed through, for example, chemical-mechanical polishing (CMP) to obtain the interconnect structure 100A for the intermediate semiconductor device 10' which may be the same as or correspond to the semiconductor device 10 shown in FIGS. 1A-1D.

In the meantime, the interconnect structure 100A of the semiconductor device 10 is characterized by not only its top via scheme but also the height difference between the wide metal lines 140-150 and the narrow metal lines 110-130 as described earlier with reference to FIGS. 7A-7C. However, when the heights of the metal lines 110-150 are different from each other, RC characteristics of the metal lines may be different from each other, and thus, estimation of connection performance of the interconnect structure 100A of the semiconductor device 10 may be difficult. Moreover, when the wide metal structures 140'-150' are excessively patterned to form the wide metal lines 140-150 having the smaller height H2, connection performance of the semiconductor device 10 may be deteriorated. Thus, the top via scheme may not sufficiently benefit connection performance of the semiconductor device 10 including the wide metal line 140 with the top via 145 thereon.

In the following embodiments are provided to address the above-described height difference between a wide metal line and a narrow metal line of an interconnect structure including top vias. In the following embodiments, an interconnect structure of a semiconductor device in which a wide metal line and a narrow metal line have an equal height and a method of manufacturing the same will be described.

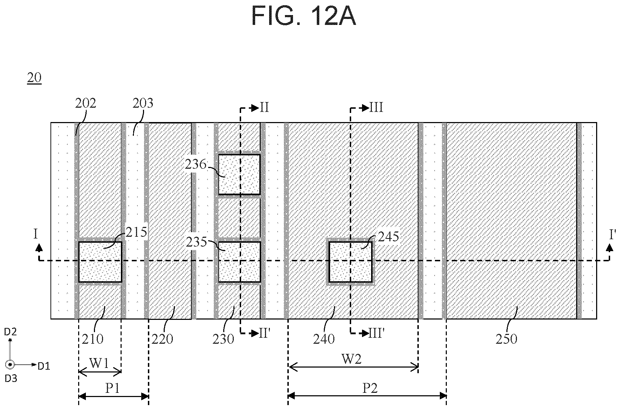

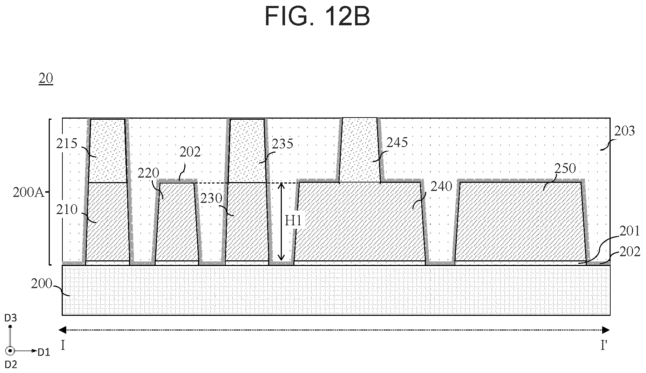

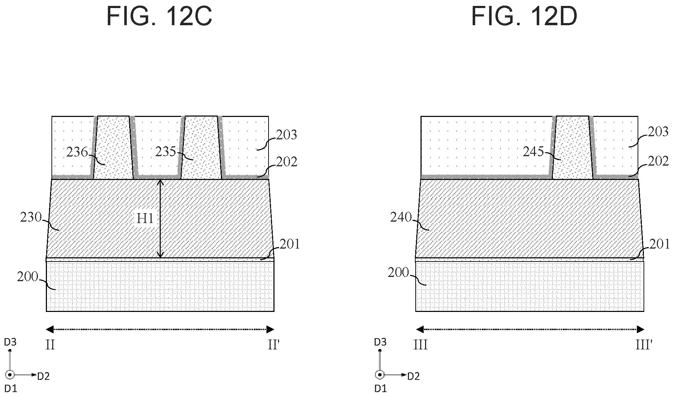

FIGS. 12A-12D illustrate a semiconductor device including an interconnect structure formed of a plurality of metal lines and top vias, according to an embodiment. FIG. 12A is a plan view of a semiconductor device including an interconnect structure, and FIG. 12B is a side cross-sectional view taken along a line I-I' shown in FIG. 12A. FIGS. 12C and 12D are side cross-sectionals view taken along a line II-II' and a line III-III' shown in FIG. 12A, respectively.

Referring to FIGS. 12A-12D corresponding to FIGS. 1A-1D, respectively, a semiconductor device 20 may include an interconnect structure 200A which is similar to the interconnect structure 100A of the semiconductor device 10 shown in FIGS. 1A-1D.

The interconnect structure 200A of the semiconductor device 20 may include 1^{st} to 5^{th} metal lines 210-250 arranged in the D1 direction and extended in the D2 direction. The metal lines 210-250 may be formed on a frontside structure 200 with a 1^{st} adhesive layer 201 therebetween. On the metal lines 210-250 may be formed 1^{st} to 4^{th} top vias 215, 235, 236 and 245, respectively. The metal lines 210-250 and the top vias 215, 235, 236 and 245 may be surrounded by an isolation structure 203 with a 2^{nd} adhesive layer 202 therebetween.

The widths and pitches of the metal lines 210-250 of the interconnect structure 200A may be equal to those of the metal lines 110-150 of the interconnect structure 100A. For example, each of the 4^{th} and 5^{th} metal lines 240 and 250 may be wider than each of the 1^{st} to 3^{rd} metal lines 210-230 in the D1 direction. Duplicate descriptions may be omitted herebelow.

The metal lines 210-250 and the top vias 215, 235, 236 and 245 may each be formed of a metal such as ruthenium (Ru), molybdenum (Mo), tungsten (W), cobalt (Co), or their compound, not being limited thereto.

The frontside structure 200, the 1^{st} adhesive layer 201, the 2^{nd} adhesive layer 202 and the isolation structure 203 may be the same as the frontside structure 100, the 1^{st} adhesive layer 101, the 2^{nd} adhesive layer 102 and the isolation structure 103 of the semiconductor device 10, and thus, duplicate descriptions may be omitted herebelow.

However, the interconnection structure 200A of the semiconductor device 20 may differ from the interconnect structure 100 A that of the semiconductor device 10 in various aspects as described below.

The top vias 215, 235, 236 and 245 of the interconnect structure 200A may include a metal or metal compound which is processed differently from that of the top vias 115, 135, 136 and 145 of the interconnect structure 100A. For example, a 1^{st} metal structure including ruthenium (Ru), not being limited thereto, may be deposited through physical vapor deposition (PVD) to form the metal lines 210-250, while a 2^{nd} metal structure including the same Ru may be deposited on the 1^{st} metal structure through chemical vapor deposition (CVD) to form the top vias 215, 235, 236 and 245.

Thus, even if the metal lines 210-250 and the top vias 215, 235, 236 and 245 may be formed of the same metal, they may have different microstructures, crystallography, or surface morphologies. For example, the metal lines formed through PVD may have a columnar material structure (e.g. having single crystalline columns extending in the third direction D3), while the top vias formed through CVD may have an amorphous or polycrystalline structure (e.g having grain boundaries intersecting the third direction). Accordingly, even if there is no intervening layer such as a barrier metal line, a boundary may exist between the top vias and the respective metal lines in the interconnect structure 200A unlike in the interconnect structure 100A of the semiconductor device 10. The boundary may be visible through scanning electron microscopy (SEM), transmission electron microscopy (TEM) or focused ion beam (FIB) microscopy.

As the metal lines 210-250 and the top vias 215, 235, 236 and 245 may have different structural characteristics as described above due to the different formation processes applied thereto, the metal lines 210-250 may have an equal height H1 after the respective top vias 215, 235, 236 and 245 are patterned out thereon.

Thus, connection performance of the semiconductor device 20 may be sufficiently benefitted by the interconnect structure 200A having a top via scheme, regardless of a width difference between a wide metal line and a narrow metal line. Further, estimation of connection performance of the interconnect structure 200A of the semiconductor device 20 may become easier than the interconnect structure 100A of the semiconductor device 10 of the previous embodiment.

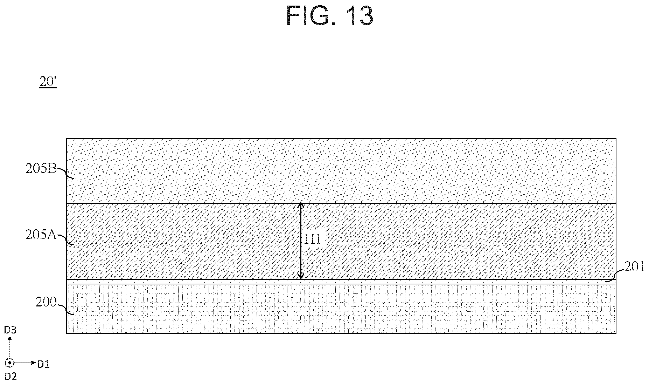

FIGS. 13-23 illustrate intermediate semiconductor devices including intermediate interconnect structures obtained from respective steps of forming an interconnect structure including a wide metal line and a narrow metal line with respective top vias thereon and having a same height, according to embodiments. Here, the interconnect structure completed from the intermediate interconnect structures through the respective steps described herebelow may be the same as or corresponding to the interconnect structure 200A of the semiconductor device 20 shown in FIG. 12A-12D. Thus, duplicate descriptions may be omitted, and the same reference numbers and characters used in the descriptions of the interconnect structure 200A of the semiconductor device 20 may be used herebelow.

Referring to FIG. 13, a 1^{st} initial metal structure 205A and a 2^{nd} initial metal structure 205B may be formed on the frontside structure 200 of an intermediate semiconductor device 20'. The initial metal structures 205A and 205B may both extend in the D1 direction and the D2 direction on the frontside structure 200 which may be at least one of an FEOL structure, an MOL structure and a BEOL structure.

Prior to formation of the initial metal structures 205A and 205B on the frontside structure 200, the 1^{st} adhesive layer 201 may be layered on a top surface of the frontside structure 200 through, for example, atomic layer deposition (ALD), not being limited thereto. Then, the 1^{st} initial metal structure 205A may be formed on the 1^{st} adhesive layer 201 through, for example, physical vapor deposition (PVD) and planarized through, for example, chemical-mechanical polishing (CMP) so that the 1^{st} initial metal structure 205A can have the height H1, which is a target height for each of the 1^{st} to 5^{th} metal lines 210-250. Subsequently, the 2^{nd} initial metal structure 205B may be formed on the 1^{st} initial metal structure 205A through, for example, chemical vapor deposition (CVD) and planarized through, for example, CMP so that the 2^{nd} initial metal structure 205B can have a target height for the 1^{st} to 4^{th} top vias 215, 235, 236 and 245. Thus, the 1^{st} initial metal structure 205A and the 2^{nd} initial metal structure 205B may be formed through different deposition processes.

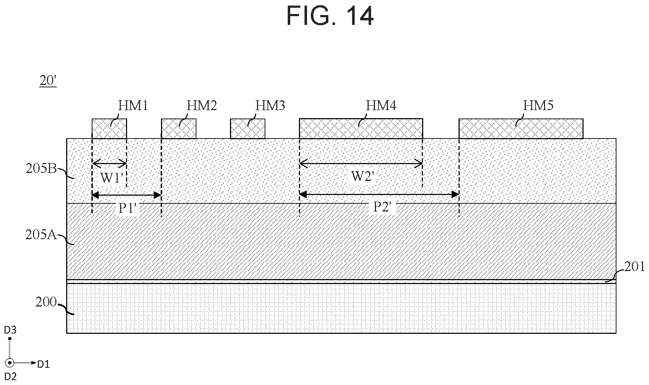

Referring to FIG. 14, 1^{st} to 5^{th} hard mask patterns HM1-HM5 may be formed on a top surface of the 2^{nd} initial metal structure 205B at position where the 1^{st} to 5^{th} metal lines 210-250 are to be respectively formed thereunder through, for example, a photolithography and masking operation.

The 1^{st} to 5^{th} hard mask patterns HM1-HM5 formed in this step may be the same as those shown in FIG. 3, and thus, duplicate descriptions about the material and the dimensions thereof may be omitted herebelow.

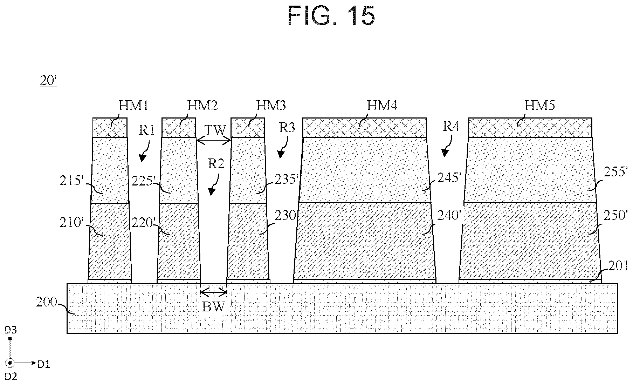

Referring to FIG. 15, the initial metal structures 205A and 205B with the 1^{st} adhesive layer 201 thereunder may be patterned based on the hard mask patterns HM1-HM5 to form 1^{st} to 5^{th} metal lines 210-250 with 1^{st} to 5^{th} via structures 215'-255' respectively thereon.

The 1^{st} initial metal structure 205A may be patterned to form the 1^{st} to 5^{th} metal structures 210'-250' which will become the 1^{st} to 5^{th} metal lines 210-250, respectively. The 2^{nd} initial metal structure 205B may be patterned to form the 1^{st} to 5^{th} via structures 215'-255' which will be further patterned to form the 1^{st} to 4^{th} top vias 215, 235, 236 and 245, respectively, in a later step. The 1^{st} to 3^{rd} metal structures 210'-230' and the 1^{st} to 3^{rd} via structures 215'-235' may form respective narrow structures, while the 4^{th} and 5^{th} metal structures 240'-250' and the 4^{th} and 5^{th} via structures 245'-255' may form respective wide structures.

The formation of the metal structures 210'-250' with the via structures 215'-255' respectively thereon may be performed through, the same process applied to the formation of the 1^{st} to 5^{th} metal structures 110'-150' shown in FIG. 2C. Thus, the same recesses R1-R4 may be formed between the metal structures 210'-250' with the via structures 215'-255' respectively thereon, and further, the dimensions thereof may be the same. Duplicate descriptions may be omitted herebelow.

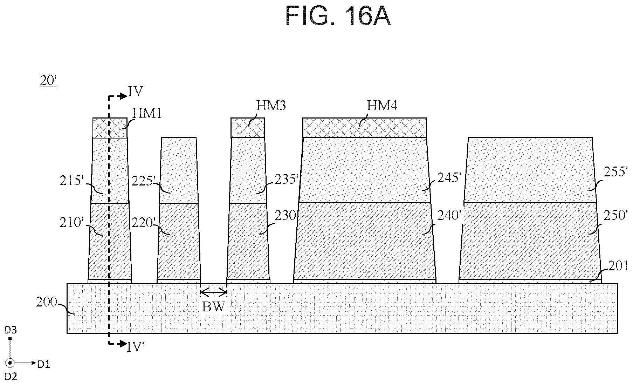

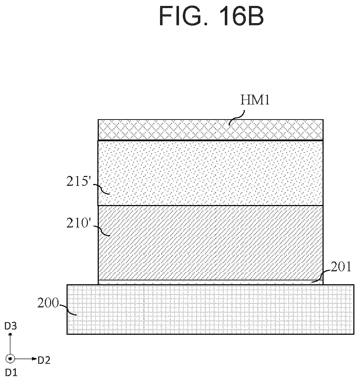

Referring to FIGS. 16A and 16B, the 2^{nd} hard mask pattern HM2 and the 5^{th} hard mask pattern HM5 among the 1^{st} to 5^{th} hard mask patterns HM1-HM5 may be removed from the 2^{nd} via structure 225' and the 5^{th} via structure 255', respectively, while the 1^{st} hard mask pattern HM1, the 3^{rd} hard mask pattern HM3 and the 4^{th} hard mask pattern HM4 remain on the 1^{st} via structure 215', the 3^{rd} via structure 235' and the 4^{th} via structure 245', respectively.

The 2^{nd} hard mask pattern HM2 and the 5^{th} hard mask pattern HM5 may be selectively removed in this step to expose top surfaces of the 2^{nd} via structure 225' and the 5^{th} via structure 255' so that these via structures can be recessed from the top surfaces thereof in a later step. The selective removal operation of the hard mask patterns HM2 and HM5 may be performed through, for example, ashing or stripping, not being limited thereto.

After the selective removal of the hard mask patterns HM2 and HM5, a side cross-sectional view in the D1 direction of the 1^{st} metal structure 210' with the 1^{st} via structure 215' and the 1^{st} hard mask pattern HM1 thereon may take a shape as shown in FIG. 16B, which is a cross-sectional view of the intermediate semiconductor device 20' along a line IV-IV' of FIG. 16A. The 3^{rd} metal structure 230' with the 3^{rd} via structure 235' and the 3^{rd} hard mask pattern HM3 thereon, and the 4^{th} metal structure 140' with the 4^{th} via structure 245' and the 4^{th} hard mask pattern HM4 thereon may have the same side cross-sectional view in the D1 direction as that of the 1^{st} metal structure 210' with the 1^{st} via structure 215' and the 1^{st} hard mask pattern HM1 thereon.

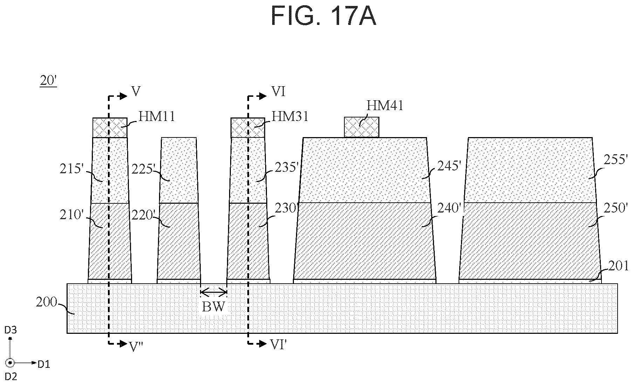

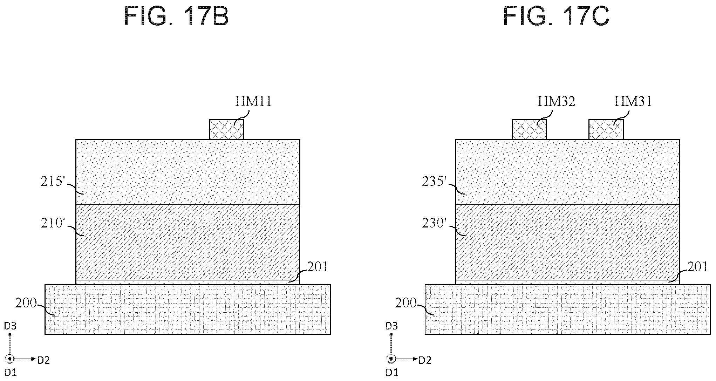

Referring to FIG. 17A-17C, the 1^{st} hard mask pattern HM1, the 3^{rd} hard mask pattern HM3, and the 4^{th} hard mask pattern HM4 may be patterned to correspond to positions where the 1^{st} top via 215, the 2^{nd} and 3^{rd} top vias 235-236, and the 4^{th} top via 245 are to be formed in a later step. FIGS. 17B and 17C are cross-sectional views of the intermediate semiconductor device 20' along lines V-V' and VI-VI' of FIG. 17A, respectively.

The patterning of the 1^{st} hard mask pattern HM1, the 3^{rd} hard mask pattern HM3, and the 4^{th} hard mask pattern HM4 in this step may be performed through, for example, another photolithography and masking operation.

After the patterning operation in this step, a reduced 1^{st} hard mask pattern HM11 may be formed on the 1^{st} via structure 215', and reduced 3^{rd} hard mask patterns HM31 and HM32 may be formed on the 3^{rd} via structure 235'. Further, a reduced 4^{th} hard mask pattern HM41 may be formed on the 4^{th} via structure 245'.

FIG. 17B shows a side cross-sectional view in the D1 direction of the 1^{st} metal structure 210' and the 1^{st} via structure 215' with the reduced 1^{st} hard mask pattern HM11 thereon, which may be the same as that of the 4^{th} metal structure 240' and the 4^{th} via structure 245' with the reduced 4^{th} hard mask pattern HM41 thereon. FIG. 17C shows a side cross-sectional view in the D1 direction of the 3^{rd} metal structure 230' and the 3^{rd} via structure 235' with the reduced 3^{rd} hard mask patterns HM31 and HM32 thereon.

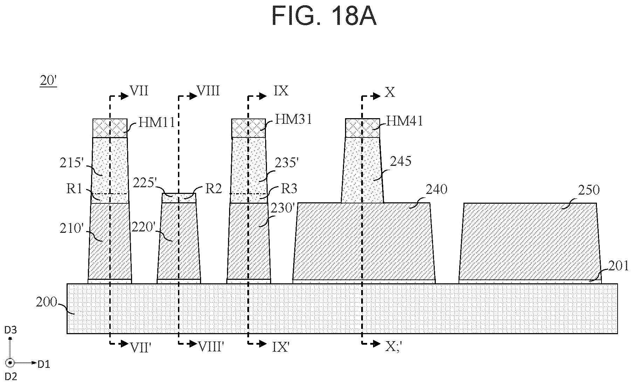

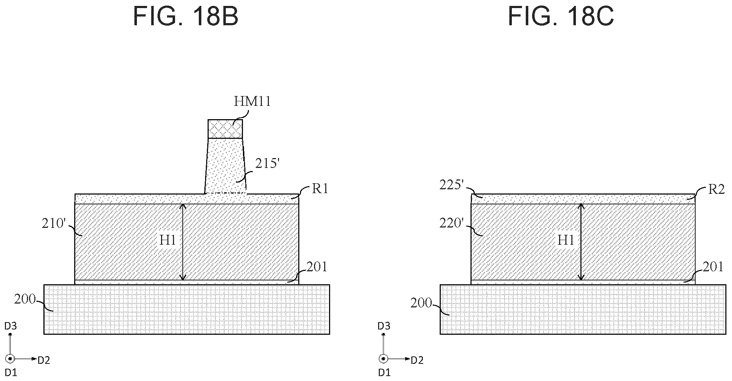

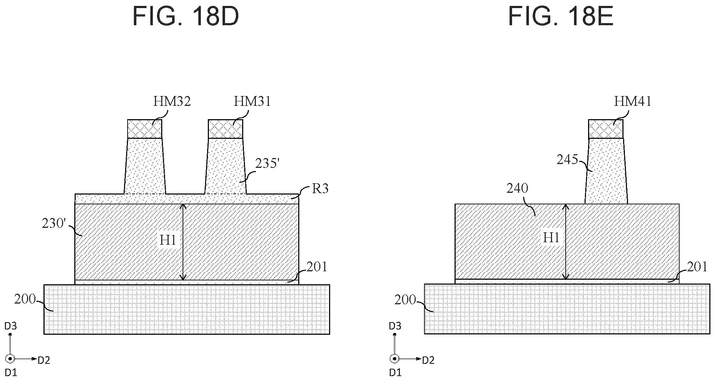

Referring to FIGS. 18A-18E, the 1^{st} to 5^{th} via structures 215'-255' may be patterned based on the reduced hard mask patterns HM11, HM31, HM32 and HM41 obtained in the previous step. FIGS. 18B-18E are cross-sectional views of the intermediate semiconductor device 20' along lines VII-VII', VIII-VIII', IX-IX' and X-X' of FIG. 18A, respectively.

By this patterning operation, the 4^{th} metal line 240 with the 4^{th} top via 245 thereon and the 5^{th} metal line 250 may be formed on the frontside structure 200 from the 4^{th} metal structure 240', the 4^{th} via structure 245' and the 5^{th} metal structure 250'. The 4^{th} and 5^{th} metal lines 240-250 formed in this step may have the target height H1. However, the 1^{st} to 3^{rd} metal lines 210-230 and the 1^{st} to 3^{rd} top vias 215, 235 and 236 have yet to be formed on the frontside structure 200.

The patterning of the metal structures 210'-250' with the via structures 215'-255' thereon may be performed through, for example, dry etching (e.g., reactive ion etching, ion beam etching, or laser ablation). When dry etching is performed, the 1^{st} to 5^{th} metal structures 210'-250' and the via structures 215'-255' with the reduced hard mask patterns HM11, HM31, HM32 and HM41 thereon may be exposed to a reactive gas in a vacuum chamber at the same time. At this time, the 4^{th} and 5^{th} via structures 245' and 255' (wide metal structures) may be etched faster than the 1^{st} to 3^{rd} via structures 215'-235' (narrow metal structures) because of the width difference thereof. For example, when the 5^{th} via structure 255' and a portion of the 4^{th} via structure 245' not covered by the reduced hard mask pattern HM 41 are entirely removed, portions of the 1^{st} and 3^{rd} via structures 215' and 235' not covered by the reduced hard mask patterns HM11, HM31 and HM32, respectively, and the 2^{nd} via structure 225' may not be entirely removed. Thus, residues R1-R3 of the 1^{st} to 3^{rd} via structures 215'-23 5' not covered by the hard mask patterns HM11, HM31 and HM32 may still remain on the 1^{st} to 3^{rd} metal structures 210'-230', respectively.

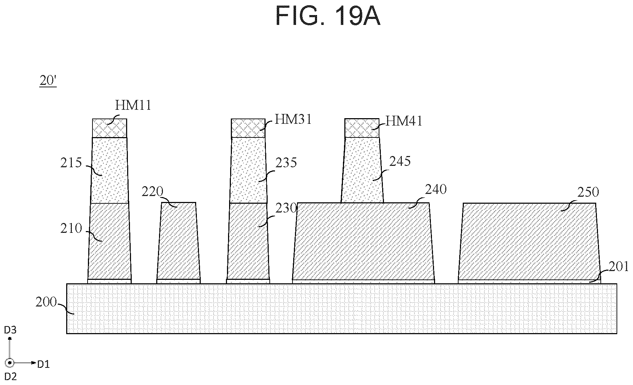

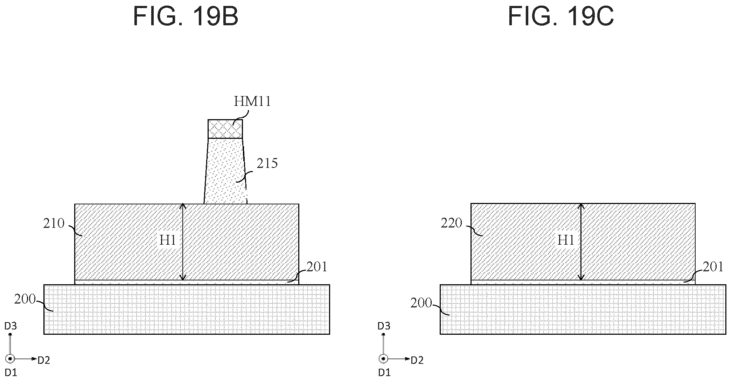

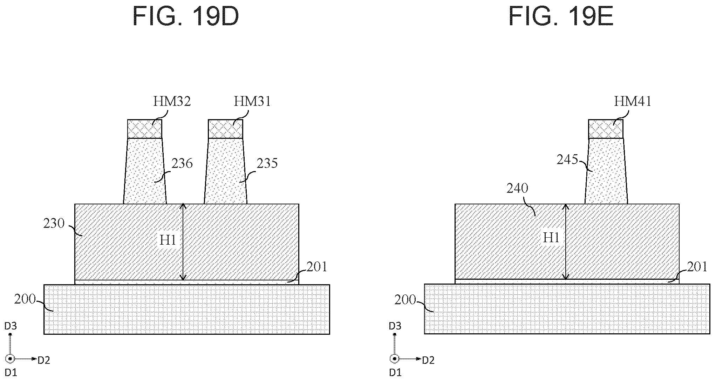

Referring to FIGS. 19A-19E, the residues R1-R3 of the 1^{st} to 3^{rd} via structures 215'-235' not covered by the hard mask patterns HM11, HM31 and HM32 may be entirely removed, thereby forming the 1^{st} to 3^{rd} metal lines 210-230 and 1^{st} to 3^{rd} top vias 215, 235 and 236.

The residues R1-R3 may be removed through, for example, dry etching continued from the previous step. For example, the dry etching that has patterned the 4^{th} top via 245 with the underling 4^{th} metal line 240 and removed the 5^{th} via structure 255' to form the underling 5^{th} metal line 250 may be continuously performed on the residues R1-R3 of the 1^{st} to 3^{rd} via structures 215'-235' not covered by the hard mask patterns HM11, HM31 and HM32.

However, while the continued dry etching in this step removes the residues R1-R3 to form the 1^{st} to 3^{rd} metal lines 210-230 having the target height H1, the 4^{th} and 5^{th} metal lines 240-250 may hold without being additionally etched by the continued dry etching or an amount of the etching may be controlled to be negligible. This is because the metal forming the 4^{th} and 5^{th} metal lines 240-250 may have been deposited through CVD while the same metal forming the residues R1-R3 of the 1^{st} to 3^{rd} via structures 215'-235' may have been deposited through PVD.

As the deposition method differs to form two different metal structures including the same metal, that is, the 1^{st} initial metal structure 205A and the 2^{nd} initial metal structure 205B in the earlier step shown in FIG. 13, an etch rate may also differ between the two metal structures, that is, the residues R1-R3 and the 4^{th} and 5^{th} metal lines 240-250. Further, the etch rate may also be controlled by selective use of etchants such as chlorine-based etchants, nitric acid-based etchants, and sulfuric acid-based etchants, not being limited thereto. Thus, even after removing the residues R1-R3 to form the 1^{st} to 3^{rd} metal lines 210-230 having the target height H1, the 4^{th} and 5^{th} metal lines 240-250 which have been formed earlier may maintain the same target height H1. Accordingly, the 1^{st} to 5^{th} metal lines may have the same target height H1 to improve the connection performance of the interconnect structure 200A of the semiconductor device 20.

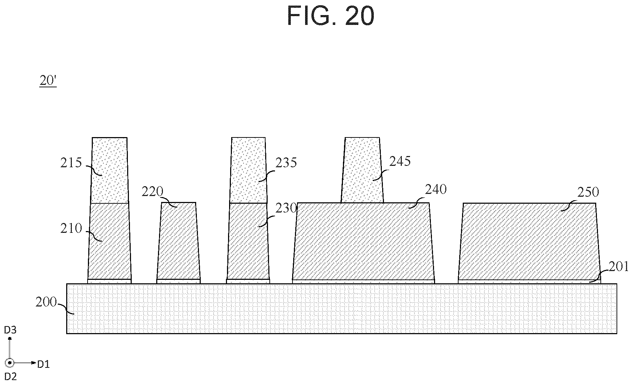

Referring to FIG. 20, the reduced 1^{st} hard mask pattern HM11, 3^{rd} hard mask patterns HM31-HM32 and 4^{th} hard mask pattern HM41 may be removed from the intermediate semiconductor device 20'.

The removal of the reduced hard mask patterns HM11, HM31, HM32 and HM41 in this step may be performed through, for example, ashing or stripping, not being limited thereto.

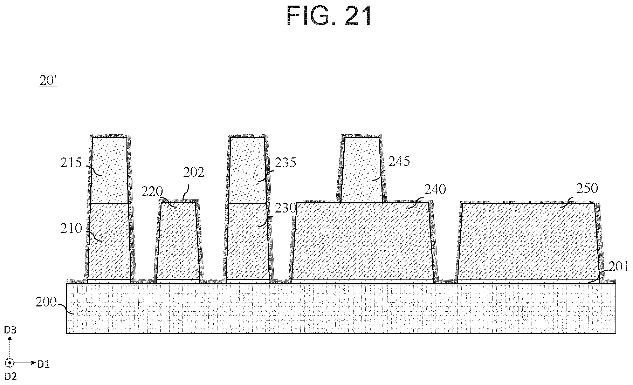

Referring to FIG. 21, the 2^{nd} adhesive layer 202 may be formed on the metal lines 210-250 and the top vias 215, 235, 236 and 245 to facilitate bonding of this intermediate interconnect structure to an isolation structure to be formed in a next step. The 2^{nd} adhesive layer 202 may also protect the intermediate interconnect structure from an annealing process that may be performed to form the isolation structure.

The formation of the 2^{nd} adhesive layer may be performed through, for example, at least one of atomic layer deposition (ALD), chemical vapor deposition (CVD), physical vapor deposition (PVD), and plasma-enhanced chemical vapor deposition (PECVD), not being limited thereto.

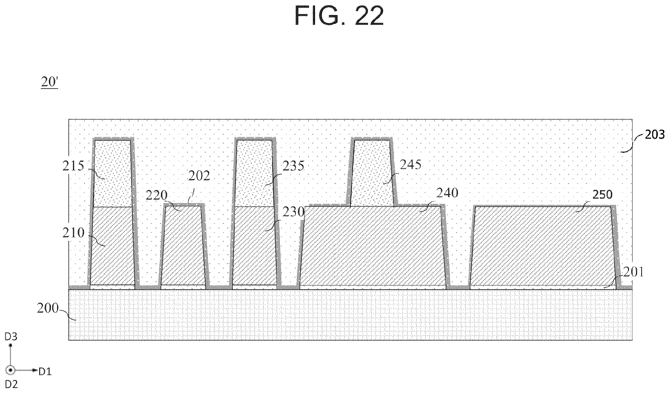

Referring to FIG. 22, the isolation structure 203 may be formed on the metal lines 210-250 and the top vias 215, 235, 236 and 245 to isolate these metal lines and top vias from each other or from other circuit elements.

The formation of the isolation structure 203 may be performed through, for example, at least one of chemical vapor deposition (CVD), physical vapor deposition (PVD), plasma-enhanced chemical vapor deposition (PECVD), and atomic layer deposition (ALD), not being limited thereto.

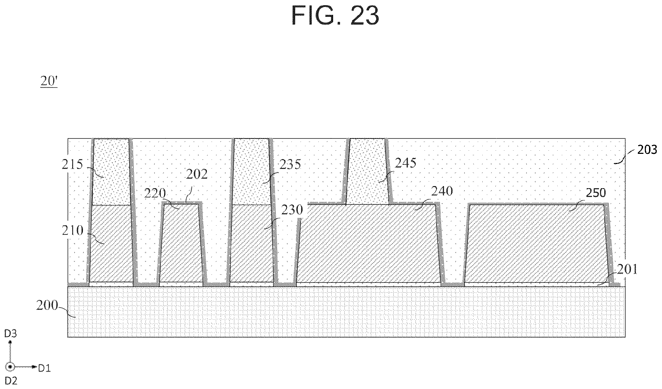

Referring to FIG. 23, the isolation structure 203 surrounding the metal lines 210-250 and the top vias 215, 235, 236 and 245 may be planarized to expose top surfaces of the top vias 215, 235, 236 and 245 for external connection of the intermediate semiconductor device 20'.

The planarization in this step may be performed through, for example, chemical-mechanical polishing (CMP) to obtain the interconnect structure for the intermediate semiconductor device 20' which may be the same as or correspond to the semiconductor device 20 shown in FIGS. 12A-12D.

In the above embodiment, ruthenium (Ru) is deposited by PVD and CVD to respectively form the metal lines 210-250 and the top vias 215, 235, 236 and 245 thereon. However, the disclosure is not limited thereto, and thus, different metals such as molybdenum (Mo), tungsten (W), cobalt (Co), etc. may also be deposited to form these metal lines and top vias. Further, the metal forming the metal lines may be deposited through CVD while the metal forming the top vias is deposited through PVD to achieve the same height for the wide metal lines and the narrow metal lines having the respective top vias thereon by controlling a pattering condition such as etching method, etch rate, etchant, etching time, etc.

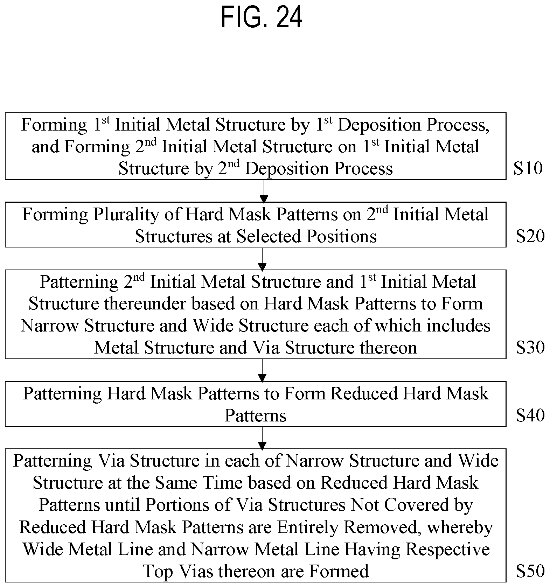

FIG. 24 illustrates a flowchart for a method of forming an interconnect structure in which a wide metal line and a narrow metal line have respective top vias thereon and have a same height, according to embodiments. This method may be described with reference to FIGS. 13-23, and thus, the same reference numbers may be used.

In step S10, a 1^{st} initial metal structure and a 2^{nd} initial metal structure stacked thereon may be provided on a frontside structure, wherein the 1^{st} initial metal structure and the 2^{nd} initial metal structure are deposited by different processes.

For example, the 1^{st} initial metal structure 205A and the 2^{nd} initial metal structure 205B may be deposited by different processes, for example, PVD and CVD (see FIG. 13).

The metal or metal compound forming the initial metal structures 205A and 205B may be the same, for example, ruthenium (Ru). The 1^{st} initial metal structure 205A may be deposited to have a target height H1 which may be a height of metal lines to be completed in a later step. The frontside structure 200 may be at least one of an FEOL structure, an MOL structure and a BEOL structure.

In step S20, a plurality of hard mask patterns may be formed on the 2^{nd} initial metal structure at positions where at least one narrow metal line and at least one wide metal line are to be formed thereunder.

For example, the 1^{st} hard mask pattern HM1 and the 4^{th} hard mask pattern HM4 may be formed on the 2^{nd} initial metal structure 205B (see FIG. 14).

In step S30, the 2^{nd} initial metal structure and the 1^{st} initial metal structure thereunder may be patterned in this order to form at least one narrow structure and at least one wide structure each of which includes a metal structure and a via structure thereon.

For example, a narrow structure may include the 1^{st} metal structure 210' with the 1^{st} via structure 215' thereon, and a wide structure may include the 4^{th} metal structure 240' with the 4^{th} via structure 245'thereon (see FIG. 15).

In step S40, the hard mask patterns may be patterned to form reduced hard mask patterns that may correspond to positions where a top via on the narrow metal line and a top via on the wide metal line are to be formed thereunder.

For example, the reduced hard mask patterns HM11 and HM41 may be formed on the 1^{st} and 4^{th} via structures 215' and 245', respectively (se FIGS. 17A-17C).

In step S50, the via structure in each of the narrow structure and the wide structure may be patterned at the same time based on the reduced hard mask patterns until portions of the via structures not covered by the reduced hard mask patterns are entirely removed, whereby a wide metal line and a narrow metal line having respective top vias thereon may be formed.

At this time, a portion of the via structure in the wide structure which is not covered by the hard mask patterns may be etched away faster than a portion of the via structure in the narrow structure which is not covered by the hard mask patterns. Thus, a top via and a wide metal line thereunder may be first formed from the wide structure while a top via and a narrow metal line thereunder has yet to be formed. This is because the via structure in the wide structure may provide a wider etchant reaction surface than the via structure in the narrow structure.

For example, the portion of the 4^{th} via structure 245' not covered by the reduced hard mask pattern HM41 is entirely removed to form the top via 245 and the 4^{th} metal line 240 thereunder before the portion of the 1^{st} via structure 215' not covered by the hard mask pattern HM 11 is entirely removed to form the 1^{st} top via 215 and the 1^{st} metal line 210 thereunder.

However, the earlier-formed 4^{th} metal line 240 may tolerate the continued patterning operation, e.g., dry etching, without being further etched until the portion of the 1^{st} via structure 215' not covered by the hard mask pattern HM 11 is entirely removed to form the 1^{st} top via 215 and the 1^{st} metal line 210 thereunder. This is because the 1^{st} initial metal structure forming the 4^{th} metal line 240 and the 2^{nd} initial metal structure forming the 1^{st} via structure 215' have been deposited through different processes, e.g., PVD and CVD (see FIGS. 18A-18E to 19A-19E).

In step S60, the reduced hard mask patterns may be removed, an adhesive layer may be layered on an outer surfaces of the top vias and the metal lines, and an isolation structure may be formed to surround the top vias and the metal lines.

For example, after removal of the reduced hard mask patterns HM11 and HM41, the 2^{nd} adhesive layer 202 and the isolation structure 203 may be formed to surround the 1^{st} metal line 210 with the 1^{st} top via 215 thereon and the 4^{th} metal line 240 with the 4^{th} top via 245 thereon.

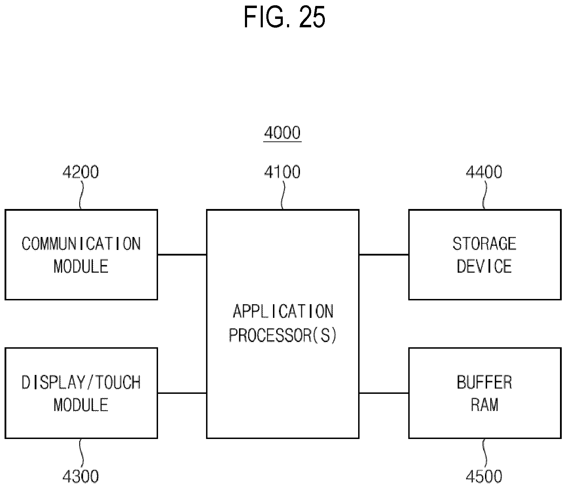

FIG. 25 is a schematic block diagram illustrating an electronic device including an interconnect structure 200A as shown in FIGS. 12A-12D, according to an example embodiment.

Referring to FIG. 25, an electronic device 4000 may include at least one application processor 4100, a communication module 4200, a display/touch module 4300, a storage device 4400, and a buffer RAM 4500. The electronic device 4000 may be a mobile device such as a smartphone or a tablet computer, not being limited thereto, according to embodiments.

The application processor(s) 4100 may control operations of the electronic device 4000. The communication module 4200 is implemented to perform wireless or wire communications with an external device. The display/touch module 4300 is implemented to display data processed by the application processor (s) 4100 and/or to receive data through a touch panel. The storage device 4400 is implemented to store user data. The storage device 4400 may be an embedded multimedia card (eMMC), a solid state drive (SSD), a universal flash storage (UFS) device, etc. The storage device 4400 may perform caching of the mapping data and the user data as described above.

The buffer RAM 4500 may temporarily store data used for processing operations of the electronic device 4000. For example, the buffer RAM 4500 may be volatile memory such as double data rate (DDR) synchronous dynamic random access memory (SDRAM), low power double data rate (LPDDR) SDRAM, graphics double data rate (GDDR) SDRAM, Rambus dynamic random access memory (RDRAM), etc.

At least one component in the electronic device 4000 may include a semiconductor device including an interconnect structure 200A shown in FIGS. 12A-12D.

The foregoing is illustrative of exemplary embodiments and is not to be construed as limiting the disclosure. Although a few exemplary embodiments have been described, those skilled in the art will readily appreciate that many modifications are possible in the above embodiments without materially departing from the scope of the appended claims.

## Claims

1. A semiconductor device comprising:
a frontside structure (200) comprising at least one of a front-end-of-line, FEOL, structure, a middle-of-line, MOL, structure, and a back-end-of-line, BEOL, structure;
a 1^{st} metal line (210) on the frontside structure (200); and
a 2^{nd} metal line (240) on the frontside structure (200),
wherein the 1^{st} metal line (210) has a greater width than the 2^{nd} metal line (240) in a same direction (D1), and
wherein the 1^{st} metal line (210) and the 2^{nd} metal line (240) have an equal height.

2. The semiconductor device of claim 1, further comprising a 1^{st} top via (215) on the 1^{st} metal line (210) without an intervening layer.

3. The semiconductor device of claim 2, wherein the 1^{st} top via (215) and the 1^{st} metal line (210) comprise a same material composition, such as ruthenium, Ru.

4. The semiconductor device of claim 3, wherein a material structure of the 1^{st} top via (215) is different from a material structure of the 1^{st} metal line (210) and the 2^{nd} metal line (240).

5. The semiconductor device of claim 4, wherein the 1^{st} top via (215) has an amorphous or polycrystalline structure, and the 1^{st} metal line (210) and the 2^{nd} metal line (240) have a columnar material structure.

6. The semiconductor device of any one of claims 2 to 5, further comprising a 2^{nd} top via (245) on the 2^{nd} metal line (240) without an intervening layer therebetween,
wherein the 1^{st} top via (215) and the 2^{nd} top via (245) have an equal height.

7. The semiconductor device of claims 6, wherein the 2^{nd} metal line (240) and the 2^{nd} top via (245) have different material structures.

8. The semiconductor device of claim 7, wherein the 1^{st} metal line (210) and the 2^{nd} metal line (240) have a same material structure, and
wherein the 1^{st} top via (215) and the 2^{nd} top via (250) have a same material structure.

9. The semiconductor device of claim 8, wherein the 1^{st} metal line (210) and the 2^{nd} metal line (240) have a columnar material structure, and the 1^{st} top via (215) and the 2^{nd} top via (245) have an amorphous or polycrystalline structure.

10. The semiconductor device of claim 9, wherein the 1^{st} metal line (210), the 2^{nd} metal line (240), the 1^{st} top via (215), and the 2^{nd} top via (245) have a same material composition.

11. The semiconductor device of claim 10, wherein the 1^{st} metal line (210), the 2^{nd} metal line (240), the 1^{st} top via (215), and the 2^{nd} top via (245) comprise ruthenium, Ru.

12. A method of forming an interconnect structure for a semiconductor device, the method comprising:
forming a 1^{st} initial metal structure (205A) by a 1^{st} deposition process;
forming a 2^{nd} initial metal structure (205B) on the 1^{st} initial metal structure (205A) by a 2^{nd} deposition process;
forming a plurality of hard mask patterns (HM1-HM5) on the 2^{nd} initial metal structure (205B) at selected positions;
patterning the 2^{nd} initial metal structure (205B) and the 1^{st} initial metal structure (205A) thereunder based on the hard mask patterns (HM1-HM5) to form at least one narrow structure and at least one wide structure each of which includes a metal structure (210', 220', 230', 240', 250') and a via structure (215'. 225', 235', 245', 255') thereon;
patterning the hard mask patterns (HM1-HM5) to form reduced hard mask patterns (HM11, HM31, HM32, HM41); and
patterning the via structure (215'. 225', 235', 245', 255') in each of the narrow structure and the wide structure at the same time based on the reduced hard mask patterns (HM11, HM31, HM32, HM41) until portions of the via structures (215'. 225', 235', 245', 255') not covered by the reduced hard mask patterns (HM11, HM31, HM32, HM41) are entirely removed, whereby a wide metal line (240) and a narrow metal line (210, 230) having respective top vias (215, 235, 236, 245) thereon may be formed.

13. The method of claim 12, wherein the 1^{st} deposition process is one of physical vapor deposition, PVD, and chemical vapor deposition, CVD, and the 2^{nd} deposition process is the other of the PVD and the CVD.

14. The method of claim 12 or 13, wherein the 1^{st} initial metal structure (205A) and the 2^{nd} initial metal structure (205B) comprises a same material composition.

15. The method of claim 14, wherein the respective top via (245) on the wide metal line (240) and the wide metal line (240) thereunder are formed earlier than the respective top via (215, 235, 236) on the narrow metal line (210, 230) and the narrow metal line (210, 230) thereunder.
